# EUROPEAN PATENT APPLICATION

(11) **EP 1 317 038 A2**
(43) Date of publication of application: **04.06.2003**
(21) Application number: 02025527.9
(22) Date of filing: 13.11.2002
(51) Int. Cl.: H01S 5/42

(54) **Integration of vcsel array and microlens for optical scanning**

(30) Priority: 13.11.2001 US 683053
(71) Applicant: Xerox Corporation, Rochester, New York 14644 (US)
(72) Inventor: Sun, Decai, Los Altos, California 94024 (US); Rosa, Michel A., San Jose, California 95134 (US)
(74) Representative: Grünecker, Kinkeldey, Stockmair & Schwanhäusser Anwaltssozietät

(57) **Abstract**

A highly compact laser scanner with no moving parts includes a vertical cavity surface emitting laser (VCSEL). A microlens is mounted directly to the light emitting surface of the VCSEL via flip chip bonding. The VCSEL array may be one or two dimensional. The laser array may be used in a variety of applications including free space optical communications.

## Description

### BACKGROUND OF THE INVENTION

### 1. Field of Invention

The invention relates generally to the field of miniaturized optical scanners.

### 2. Description of Related Art

Optical communications systems which employ optical scanning and other optical systems often employ laser light sources. In recent years, a particular type of laser, a vertical cavity surface element laser, or VCSEL, has come into use as a laser light source for optical systems. One of many applications which use optical scanning in general, and VCSEL scanning in particular, is free space optical communications, which encompass telecommunications, cable and satellite television.

Some optical beam scanning systems use mechanically driven scanning elements which require complex drive systems and relatively high power requirements to operate. Still other scanning systems include using deformable micro mirrors which operate in response to electric field changes. Other scanning systems include acousto-optical light beam deflection. Yet other scanning systems use electro-optical or magneto-optical beam deflectors. Many of these systems use optically-phased arrays which operate analogously to radio-frequency phased-array radar systems. However, the optical scanning systems described above are limited in terms of beam switching speeds and deflection angles.

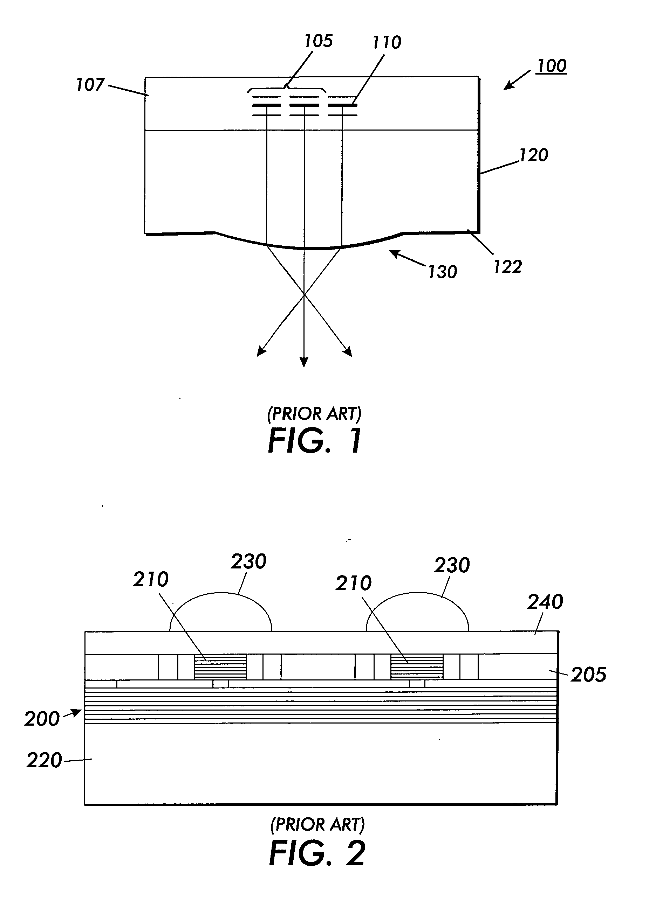

Miniaturized laser beam scanners also exist for use in various optical scanning applications, including image formation and free space optical communication systems. One prior art miniature laser scanning array, known as a monolithic integration of a VCSEL array with a microlens, is shown in Fig. 1. This monolithic integrated VCSEL comprises a VCSEL array and a built-in microlens formed in the GaAs substrate of the VCSEL. One problem with the device shown in Fig. 1 is that the VCSEL substrate material has to be transparent to the laser wavelength.

Another example of a miniature solid state laser array is disclosed in U.S. Patent 6,121,983, incorporated by reference herein in its entirety. The '983 patent discloses a linear array of laser faces of a vertical cavity surface effect laser (VCSEL) array. The light output of this laser array is scanned using a mirror array. Each VCSEL element is provided with a microlens to reduce the divergence of the laser beam emitted by that VCSEL element. Each microlens is separated from its corresponding VCSEL element by a spacer to permit the focal point of the lens to coincide with the location of the corresponding VCSEL element. The scanning is performed using the mirror array. VCSEL elements having attached microlenses element to reduce laser light beam divergence are illustrated in Fig. 2.

Another prior art VCSEL array is disclosed in U.S. Patent 6,246,708, incorporated by reference herein in its entirety. The '708 patent discloses a VCSEL array which integrated electronic components including matrix addressing circuitry, in the form of transistor elements, which allow addressing of the laser structure.

### SUMMARY OF THE INVENTION

A need exists for a micro laser scanner which overcomes the problems associated with the aforementioned prior art devices.

This invention provides a micro laser beam scanner formed by integrating a refractive microlens on a VCSEL array.

This invention separately provides methods for integrating a refractive microlens onto a VCSEL array.

This invention separately provides an integrated refractive microlens and methods for integrating a refractive microlens onto a linear array of VCSEL elements.

This invention separately provides an integrated refractive microlens and methods for integrating a refractive microlens onto a two-dimensional array of VCSEL elements.

This invention separately provides an integrated refractive microlens and methods for integrating a refractive microlens onto a circular array of VCSEL elements.

In various exemplary embodiments, integrating the microlens and the VCSEL array is achieved by flip-chip bonding a microlens chip on a VCSEL substrate. In various exemplary embodiments of the systems and methods of this invention, the microlens is used to direct the optical output from individual pixels of the VCSEL array in different directions. Such systems can be used not only in free-space communications, but also in other optical beam scanning applications, such as, for example, xerographic exposure systems, optical radars, etc.

The micro laser scanner according to this invention is designed to work for any laser wavelength and with any optical materials. The proposed micro laser scanner involves no moving parts.

These and other features and advantages of this invention are described in or are apparent from the following detailed description of various exemplary embodiments of the systems and methods according to this invention.

### BRIEF DESCRIPTION OF THE DRAWINGS

Various exemplary embodiments of this invention will be described in detail with reference to the following figures, wherein:

Fig. 1 shows a prior art monolithic integrated VCSEL array with a microlens for laser beam scanning;

Fig. 2 shows a prior art VCSEL array with microlens for each VCSEL emitter and a mirror scanner;

Fig. 3.is a cross sectional view of one exemplary embodiment of a micro laser scanner according to the invention;

Fig. 4 is a plan view of a one-dimensional array embodiment of a micro laser scanner according to the invention;

Fig. 5 is a plan view of a two-dimensional array embodiment of a micro laser scanner according to the invention; and

Fig. 6 is a plan view of a circular two-dimensional array embodiment of a micro laser scanner according to the invention.

Fig. 7 is a cross-sectional view of a vertical cavity surface emitting laser structure and integrated electronic circuit components usable with the invention.

Fig. 8 is a plan view of the device shown in Fig. 7.

### DETAILED DESCRIPTION OF PREFERRED EMBODIMENTS

A more complete appreciation of the invention and many of the attendant advantages thereof will be readily appreciated and understood by referring to the following detailed description and the accompanying drawings in which like reference numerals denote like elements as between the various drawings. Various features and advantages of the invention will become more apparent upon study of the following description, taken in conjunction with the drawings, in which:

Fig. 1 shows a cross-section of a prior art monolithic integrated vertical cavity surface effect laser (VCSEL) device 100. The VCSEL device 100 has a plurality of pixels or elements 110 that are arranged in a one-dimensional array 105. The VCSEL pixels or elements 110 are formed as part of a semiconductor laser structure 107. A gallium arsenide (GaAs) layer 120 is formed over an emitting surface of the VCSEL pixels or elements 110. A microlens 130 is formed on a surface 122 of the GaAs layer 120 opposite the surface of the GaAs layer that is adjacent to the VCSEL pixels or elements 110. The VCSEL device 100 has a limited operational bandwidth because the GaAs substrate is highly absorptive of the laser light emitted by the VCSEL elements 110, when the wavelength of the emitted laser light is shorter than 850 nm.

Fig. 2 shows a second conventional VCSEL device 200 having microlenses 230. As shown in Fig. 2, the VCSEL device 200 includes a substrate 220 on which an array 205 of the VCSEL pixels or elements 210 is formed. A spacer layer 240 is formed on or over the VCSEL pixels or elements 210. A plurality of microlenses 230 is formed on or over the spacer layer 240. Each of the microlenses 230 is associated with one of the VCSEL pixels or elements 210. Each microlens 230 reduces the divergence of the laser beam emitted by the corresponding VCSEL element 210. Each microlens element 230 is spaced from each corresponding VCSEL element 210 by the spacer layer 240 so that each VCSEL element 210 is located at the focus of the corresponding microlens 230.

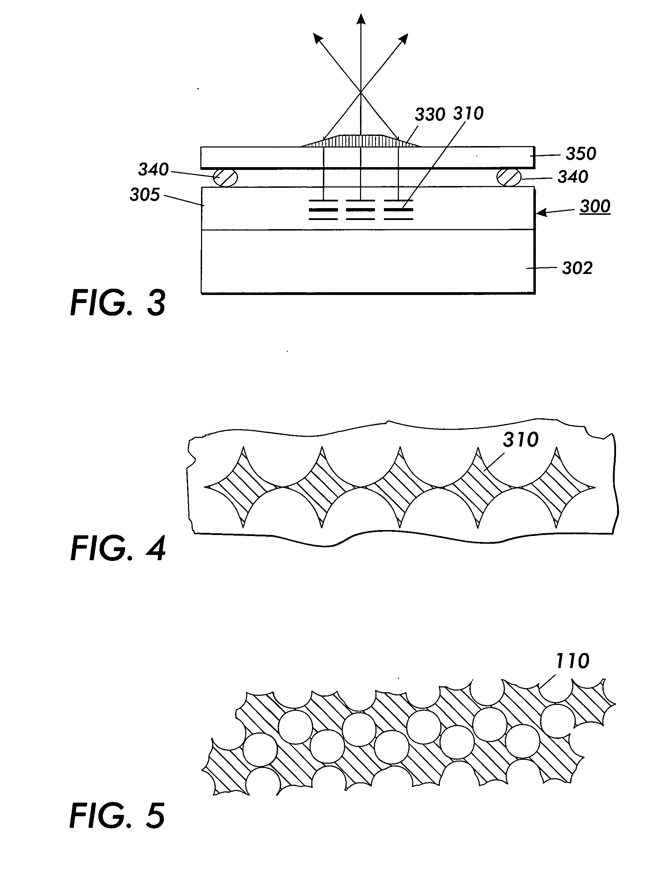

Fig. 3 shows an exemplary embodiment of an integrated device 300 according to this invention. As shown in Fig. 3, the integrated device 300 includes a substrate layer 302. A semiconductor structure 307 is formed on or over the substrate layer302. The semiconductor structure 307 includes an array 305 of two or more VCSEL elements 310. A substrate or plate 350 is attached to the semiconductor structure 307 via solder bumps 340. This type of bond arrangement is known as flip chip bonding. In various exemplary embodiments, the substrate or plate 350 may be made of, for example, quartz or any material with a suitable refractive index and dimensional stability.

A microlens 330 is formed on or over the plate 350 such that the microlens 330 is positioned geometrically over the array 305 of the VCSEL elements 310. Outputs from different VCSEL elements are refracted to different directions after passing through the microlens 330. Scanning is thus obtained by sequentially turning on and off different ones of the VCSEL elements 310.

Accuracy of alignment between the VCSEL pixels or elements 310 and the microlens 330 is achieved by reflowing the solder bumps 340 located between the semiconductor structure 301 and the substrate 350 carrying the microlenses 330. Solder wetting metal pads (not shown) are provided on both the surface of the semiconductor structure 307 and on the surface of the substrate 350 which faces the VCSEL pixels/elements 310. The VCSEL device 300 can be fabricated using the techniques set forth in U.S. Patent No. 6,208,681, incorporated herein by reference in its entirety.

The '681 patent allows fabrication of the VCSEL pixels or elements 310 in the arrays 305 at pitches or spacings between centers of the VCSEL pixels or elements 310 of less than about 7 µm. In various exemplary embodiments, where the VCSEL array pitch is about 6 µm, a suitable microlens focal length would be 500 µm. The center of the array 305 of the VCSEL pixels or elements 310 is generally located at the focal point of the microlens 330. In such an arrangement, the scan angle which can be obtained from this exemplary embodiment of the integrated VCSEL according to this invention by turning on in sequence two adjacent VCSEL pixels or elements 310 in sequence is 0.68 degree. Thus, in an array 305 having 10 VCSEL pixels or elements 310, where each pixel is turned on in sequence, a scan angle of 6 degrees can be obtained.

Fig. 4 is a top plan view of a one-dimensional array 305 having 5 VCSEL pixels or elements 310. The number of VCSEL pixels or elements 310 shown in Fig. 4 is illustrative only, and may vary depending on the application.

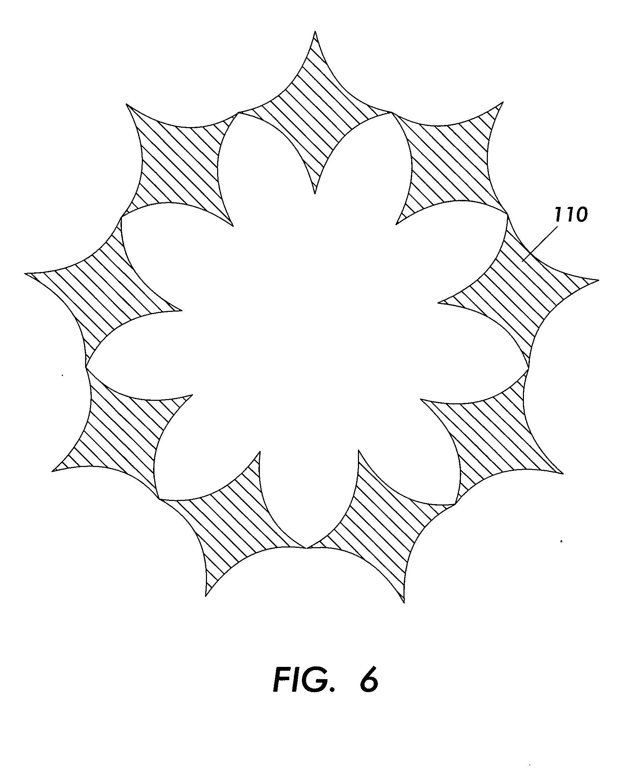

Figs. 5 and 6 show other exemplary embodiments of the integrated VBCSEL of this invention. Instead of providing a one-dimensional array 305 of the VCSEL pixels or elements 310, as shown in Fig. 4, Figs. 5 and 6 show two-dimensional arrays 305 of VCSEL pixels or elements 310.

Fig. 6 illustrates a two-dimensional array 305 of the VCSEL pixels or elements 310 set out in a circular pattern centered at the axial focus of the microlens 330. This arrangement will result in a beam scan pattern in the form of a spherical cone.

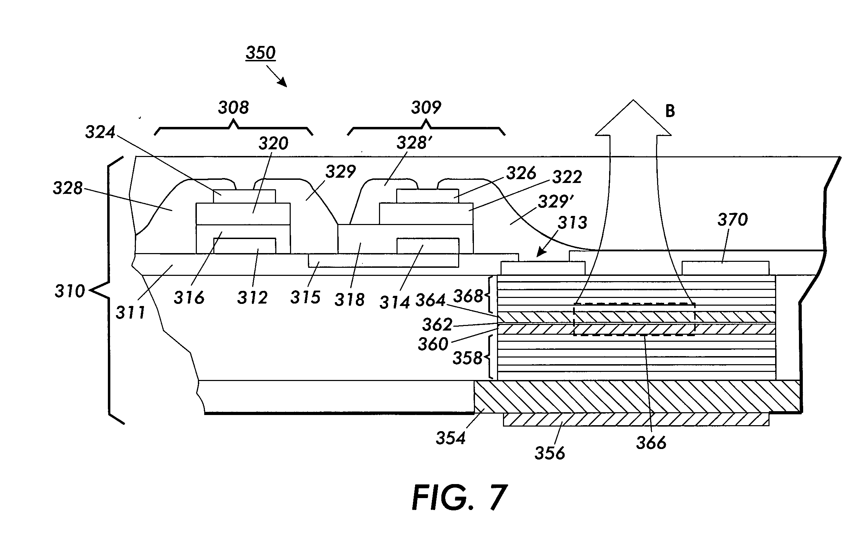

Fig. 7 illustrates a vertical cavity surface emitting laser structure and integrated electronic component structure usable with the invention. This structure is disclosed in greater detail in U.S. Patent 6,246,708 incorporated herein by reference in its entirety. The integrated VCSELs according to this invention may incorporate integrated scanning electronic components, as disclosed in Fig. 7 or may use external addressing and scanning circuitry, which is also disclosed in the '708 patent.

Fig. 7 shows a vertical cavity surface emitting laser (VCSEL) pixel 310. VCSEL pixel element 310 includes a substrate 354, a lower mirror structure 358, spacer layers 364 and 360 above and below an active layer 362, and an upper mirror structure 368, through which laser light beam B is emitted. A passivation layer 311 is provided over the VCSEL pixel element 310. Fig. 7 also shows first and second transistor structures 308 and 309, each having gate electrodes 112 and 114, respectively, and insulating layer 116 and 118, respectively. Channel materials 320 and 322, respectively, are provided over the gate electrodes. Passivation material 324 and 326, respectively is provided over the channel materials 320, 322, respectively.

A source 328 and drain 330 are provided for the first transistor 108, and a source 328' and drain 329' are provided for second transistor 309. The drain 329 is in electrical communication with the gate 314 through a conductive region 315. Similarly, drain 329 is in electrical communication with electrode 370 of the laser structure through a conductive via 313.

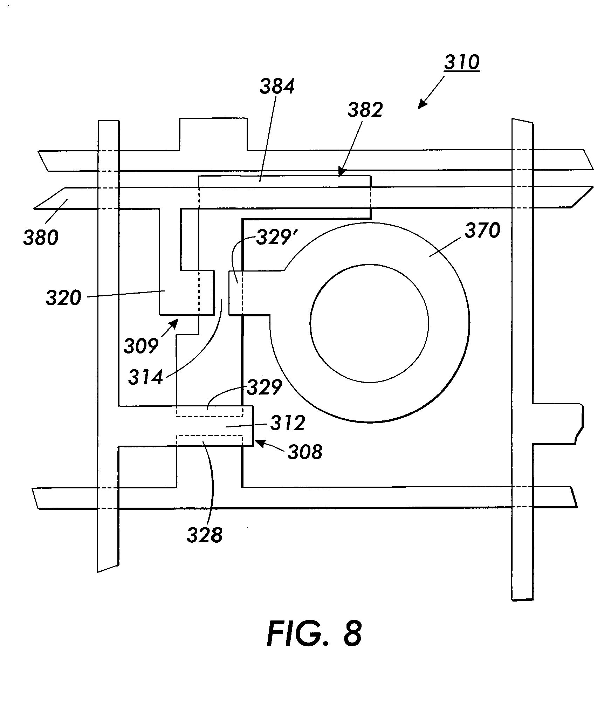

Fig. 8 is a plan view of the device shown in Fig. 7, showing one embodiment of the integrated VCSEL and associated electronic components 310. In a three-dimensional array, there may also be VCSELs 310 above and below the shown VCSEL 310. A voltage from a voltage source (not shown) is applied to a drive line 380 to drive the VCSEL 310. Fig. 8 also shows a capacitor 382 which connects the gate 314 of the transistor 308 and the drive line 380. The capacitor 382 comprises an extension of the gate contact material of the transistor 309 which underlies part of the drive line 380.

Details of operation of the array are set forth in the incorporated '708 patent. The flip-chip microlens array pixels 310 disclosed herein may be turned on and off using the circuitry shown in Figs. 7 and 8.

It should be understood that the array 305 of VCSEL pixels or elements 310 need not be centered along the axis of the microlens 330, but may be shifted in any direction by any amount as long as beam deflection of at least one of the VCSEL pixels or elements 310 occurs.

The microlenses 330 used in this invention may be fabricated on any suitable substrate 350 that results in transmission of a broad wavelength band or bands of light beams which can be generated by the VCSEL lasers 310 of the array 305 and also of any pump light should those lasers be able to be optically pumped. Suitable substrate materials include glass and quartz, among others.

In one exemplary embodiment of a method for fabricating the microlens chip 330 according to this invention, the substrate 350, formed of quartz, was flip chip bonded to the semiconductor structure 307. Then, one or more thick dielectric films of SiO₂ (not shown) were deposited on or over the substrate 350.
Next, a microlens 330 was formed in or on the SiO₂ layers formed on or over substrate 350 by reflowing a photoresist pattern. Then, the microlens 330 was transferred to the substrate 350 by one-to-one plasma etching.

In another exemplary embodiment, the refractive microlenses 330 may be obtained commercially, and deposited directly on or over the substrate 350. In various exemplary embodiments, a microlens 330 may be made of quartz, which has a refractive index of 1.455, silicon., which has a refractive index of 3.5, or a nitride. The refractive indices of nitrides varies depending on the type of nitride used, but for the various exemplary embodiments of the microlens 330 according to this invention, a reasonable assumption for the refractive index of a nitride microlens 330 is about 2.03. In various exemplary embodiments of this invention, a microlens 330 diameter may be about 130 microns, the difference in thickness from the relatively thin edge to the relatively thick center of a microlens 330 may be about 5 microns, and the focal length of a microlens 330 is equal to the radius of curvature of the microlens 330 divided by the refractive index of the microlens minus 1, i.e., focal length = ((radius of curvature)/(refractive index -1)).

## Claims

1. A micro laser array comprising:
an array having a plurality of vertical cavity, surface emitting laser elements that emit light through an emitting surface;
a microlens attached to the emitting surface via flip chip bonding involving solder bumps;
drive actuators to sequentially activate a plurality of vertical cavity surface emitting laser elements to emit light that is transmitted through the microlens.

2. The micro laser array of claim 1, wherein the microlens includes a substrate and a refracting lens element mounted at least over the substrate.

3. The micro laser array of claim 2, further comprising a layer of material located between the substrate and the refracting lens element.

4. The micro laser array of claim 1, wherein the microlens is made at least in part of quartz.

5. The micro laser array of claim 1, further comprising solder wetting pads located on at least one of the microlens and the light emitting surface.

6. The micro laser array of claim 5, wherein solder wetting pads are located on the microlens substrate.

7. A method of aligning the microlens of claim 1 with the surface of the VCSEL by reflowing the solder bumps.

8. The laser array of claim 1, wherein the microlens is made at least in part of glass.
